# EUROPEAN PATENT APPLICATION

(11) **EP 4 531 167 A1**
(43) Date of publication of application: **02.04.2025**
(21) Application number: 23200331.9
(22) Date of filing: 28.09.2023
(51) Int. Cl.: H01M 10/48, H01M 10/44, H01M 50/569, H01M 10/42, G01R 31/382, G01R 31/392, H01M 10/04, H01M 50/609, H01M 4/04, H01M 10/052, H01M 50/105

(54) **DIAGNOSIS OF BATTERY CELLS BY CURRENT FLOW MEASUREMENTS DURING MANUFACTURING**

(71) Applicant: Melexis Technologies SA, 2022 Bevaix (CH)
(72) Inventor: PUT, Brecht, 3980 Tessenderlo (BE); VANGERVEN, Tim, 3980 Tessenderlo (BE)
(74) Representative: Bardehle Pagenberg Partnerschaft mbB Patentanwälte Rechtsanwälte

(57) **Abstract**

A method for determining current flow in a battery cell during manufacturing of the battery cell is provided. The method comprises arranging a contactless current sensor relatively to the battery cell, wherein the contactless current sensor comprises at least one current sensing element; performing at least one of: filling the battery cell with an electrolyte, charging the battery cell, and discharging the battery cell; and determining, by the contactless current sensor, a current flow within the battery cell during or after said at least one of the filling the battery cell with the electrolyte, the charging the battery cell, and the discharging the battery cell. Further, a contactless current sensor, and a corresponding manufacturing equipment are provided.

## Description

### TECHNICAL FIELD

The invention of the current application relates to diagnosis of battery cells by current flow measurements during manufacturing of the battery cells. In this regard, the manufacturing of the battery cells may include the steps of filling the battery cells with electrolyte or formation of the battery cells. The current application provides a method for determining current flow in a battery cell during manufacturing, a current sensor configured to determine current flow during manufacturing of a battery cell, a manufacturing equipment comprising a corresponding current sensor as well as a battery cell being produced by a method that involves the determination of current flow during manufacturing.

### BACKGROUND

Batteries, such as lithium ion batteries, are widely used in diverse technical fields. Usually, a battery comprises a plurality of battery cells. Such battery cells usually are produced in manufacturing equipments. Manufacturing equipments for manufacturing battery cells may perform one or more steps of a manufacturing procedure. These steps may include the steps of filling the battery cells with electrolyte or formation of the battery cells. Example of manufacturing equipments may be electrolyte filling equipments, in which the battery cells are filled with electrolyte. Other examples of manufacturing equipments may be formation equipments, in which the battery cells are subsequently charged and discharged in cycles until they reach the desired capacity. Similarly, a manufacturing equipment in the sense of the current application may also be configured to perform multiple steps of the manufacturing of the battery cell. For example, a manufacturing equipment may performe electrolyte filling as well as formation.

Production of battery cells often is prone to high yield loss, in particular at the startup of a new production line. Unfortunately, detection of faulty cells conventionally only takes place at the end of the formation cycle, e.g. by means of electrochemical read out, or even only when the battery cells are used. Faulty battery cells may adversely affect the capacity of a battery and may even reduce the lifetime of the battery.

Hence, there is a need in the art for detecting faulty cells already during formation of the cells.

### SUMMARY

The abovementioned need is addressed by a method for determining current flow in a battery cell during manufacturing of the battery cell according to the independent claims. The method may be applied during or after a step of battery cell manufacturing, for example when a battery is filled with an electrolyte or when a battery cell is formed with a formation equipment.

According to the invention, the method comprises arranging a contactless current sensor relatively to the battery cell, wherein the contactless current sensor comprises at least one current sensing element. A (contactless) current sensor in the sense of the present application can be used for determining a current flow in a circuit or an electronic component of a circuit without the (contactless) current sensor necessarily being electronically connected to said circuit. This can be achieved by measuring a physical quantity that is influenced by the current in the circuit or the electronic component of the circuit, respectively. Examples of such a physical quantity may include a magnetic field (including any of the characteristics of the magnetic field, such as one or more spatial components of the magnetic field, orientation of magnetic field lines, one or more gradients of a magnetic field, a differential magnetic field, magnetic flux density (i.e. B field or one or more of its spatial components), magnetic field strength (i.e. H field or one or more of its spatial components), among others) or a temperature (including temperature gradients), among others. The person skilled in the art will appreciate that any of these measurements may include measurements that are indicative of any of the aforementioned examples, for example measuring a magnetic field by ease of the Hall effect or any magnetoresistance effect.

Further, at least one of the following is performed: filling the battery cell with an electrolyte, charging the battery cell, and discharging the battery cell. These steps may represent steps of the manufacturing of the battery cell, wherein usually the battery cell is filled with electrolyte first and afterwards the battery cell usually is formed by alternately charging and discharging the battery cell. According to the invention, a current flow within the battery cell is determined by the contactless current sensor during or after said at least one step of battery manufacturing. All combinations of performing the current flow determination during or after any of the mentioned manufacturing steps, including combinations of multiple steps, are encompassed by the current disclosure. In some preferred examples, the current flow may be determined during the charging the battery cell, during the discharging the battery cell or during both charging and discharging. In some other preferred examples, the current flow may be determined after the electrolyte filling. Determining the current flow after the electrolyte filling may, in some example, require applying a potential to the battery cell in order to facilitate current flow.

The current flow within the battery cell may be indicative of one or more characteristics associated with the battery cell. These characteristics include the cell's capacity, the cell's voltage, the cell's internal impedance, the impedance of one or more of the cell's electrodes, the impedance of the cell's electrolyte, a self-discharge rate of the cell, or a wetting of the battery cell by the electrolyte. Each of these characteristics or the deviation of these characteristics from norm values and/or the deviation from characteristics of other cells may provide an early indication of a faulty cell. For example, the determination of a current flow during formation of the battery cell may enable the detection of faulty battery cells by comparing the current flow to an expected current flow or comparing the current flow of several battery cells that are formed and sensed simultaneously. In some embodiments, spatially resolved maps of the spatial distribution of the electric current during or after the steps of manufacturing can be obtained, which can be analyzed to identify anomalies that may indicate a faulty cell. More details on the determination of the current flow will be presented below when preferred embodiments of the invention are discussed. The aforementioned deviations of the characteristics may also be called anomalies.

By the aforementioned detection of faulty battery cells during the manufacturing of the battery cells (e.g. during or after the electrolyte filling or during formation of the battery cells), the abovementioned need is overcome and will substantially improve the efficiency and quality of battery cell manufacturing.

A battery cell in the sense of the current invention may, for example, be a pouch cell, a prismatic cell, a coin/button cell, or the like. Depending on the geometry and structure of the battery, the method maybe applicable to a single cell of the battery, a pair of cells, a plurality of cells, or to the entire battery.

In some preferred embodiments, the at least one current sensing element may be any of a Hall element, a magnetoresistance element, a magnetoimpedance sensing element (e.g. giant magnetoimpedance (GMI)), a fluxgate magnetometer, a microelectromechanical system (MEMS) magnetometer, or an inductive sensing element. A magnetoresistance element is an element that is sensitive to a magnetoresistance effect, including the colossal magnetoresistance (CMR) effect, the giant magnetoresistance (GMR) effect, and the tunnel magnetoresistance (TMR) effect.

These current sensing elements may at least partially be made of a semiconductor (e.g. silicon). For example, they may comprise an integrated complementary metal-oxide semiconductor (CMOS) circuit or they may be made of a semiconductor compound, e.g. a compound comprising substances from chemical groups III and V, such as gallium arsenide (GaAs). Such configurations may improve the sensitivity of the current sensing elements.

In some preferred embodiments, the contactless current sensors may be configured to measure spatial components of the magnetic field. In order to achieve this, the contactless current sensors may comprise sensing components that are sensitive to one spatial magnetic field component, two spatial magnetic field components, or even three spatial magnetic field components. Depending on the number of spatial magnetic field components the contactless current sensors are able to measure, the contactless current sensors may be referred to as 1D, 2D, or 3D sensors.

In some preferred embodiments, the determining the current flow within the battery cell may be based on measurement of a magnetic field gradient. A measurement of a magnetic field gradient may be performed by measuring a change of one or more spatial magnetic field components along one or more spatial directions. This way, one to nine gradients may be measurement - either simultaneously or subsequently depending on the current sensor that is used. For example, in a three-dimensional Euclidean (x, y, z)-space, a change in the spatial x-component may be determined along the y-direction, which represents a single gradient. An example of two gradients would be to measure a change in two spatial magnetic field components (e.g. x-component and y-component) along a spatial direction (e.g. the y-direction). Alternatively, a single spatial magnetic field component may be measured along two spatial directions (e.g. the y- and z-directions). For six gradients, three spatial components may be measured along two spatial directions or two spatial components may be measured along three spatial directions and for nine gradients, three spatial components may be measured along three spatial directions. Noteworthy, the spatial direction along which the change in the one or more magnetic field components is determined does not need to correspond to the three main axis of the three-dimensional space. Instead, the change in the one or more magnetic field components may be determined in any arbitrary spatial direction, including but not limited to the (x, y)-, (y,z)-, and (x,z)-direction. In the foregoing description, all combinations of the three spatial magnetic field components measured along arbitrary spatial directions are included in the scope of the current disclosure, even though only some examples were explicitly mentioned.

A gradient may be determined by using a single sensing element that is intrinsically sensitive to a gradient of the magnetic field (e.g. an MEMS gradiometer), or a gradient may be determined by determining a difference between two sensing elements arranged relatively to one another along the spatial direction in which the gradient is to be determined. The latter may be facilitated by arranging current sensing elements in an array, as will be explained in the following paragraphs.

In some preferred embodiments, the at least one contactless current sensor may comprise an array comprising a plurality of current sensing elements. Equipping a current sensor with a plurality of current sensing elements allows to improve the spatial resolution of the current sensor and may allow to identify regions of the battery cell in which the current flow may be abnormal (e.g. less than expected). The current sensing elements of the plurality of current sensing elements may be distributed in a preferred manner. For example, the plurality of current sensing elements may be evenly distributed in a plane. Such a configuration has the benefit that the current flow may be determined with a substantially homogeneous spatial resolution.

Alternatively, the current sensing elements of the plurality of current sensing elements may be unevenly distributed. This may allow to adjust the spatial resolution of the current sensor to geometric properties of the battery cell. For example, for some battery cells, it may be known that the anomalies in the current flow occur more often at edge regions of the battery cell compared to a center region. In this case, the plurality of current sensing elements, when arranged relatively to the battery cell, may be more densely distributed in edge regions of the battery cell compared to the center region of the battery cell. For example, the current sensor may have a similar spatial extend as the battery cell, such that a first set of current elements of the plurality of current sensing elements located in edge regions of the current sensor may be more densely distributed than a second set of current sensing elements of the plurality of current sensing elements that may be located in a center region of the current sensor.

In case that the current sensor comprises two or more current sensing elements, the determining the current flow within the battery cell may be performed simultaneously for every current sensing element or may be performed sequentially for subgroups of the current sensing elements. Each subgroup may consist of one or more current sensing elements. In particular when the plurality of current sensing elements comprises a large number of current sensing elements, performing the determination sequentially may reduce bandwidth of the measurement signals that are provided by the current sensing elements. On the other hand, performing the determination simultaneously may provide the highest measurement accuracy and may improve comparability of the results.

In some embodiments, the determining the current flow within the battery cell may be performed at repeating time instances. For example, the determining the current flow may be performed continuously, e.g. periodically repeated according to a predetermined time interval. The data may be stored in a memory (e.g. a working memory (such as a random access memory) or a main storage). In case that the data is stored, the data may be used to monitor the electrical current over time, which allows to identify anomalies that result in abnormal or instable current rates. Depending on the frequency at which the current flow is determined, the amount of data may be huge in case that the data is stored. Therefore, it may be necessary to selectively store the data. This may be achieved, for example, by not storing the data every time data is acquired. For example, the data may only be stored at specific time instances, at specific points during the formation cycle (e.g. once a certain percentage of the formation is performed), or only the most recent data may be kept and replaced after new data has been acquired and evaluated.

It may be known that some battery cells may have specific time characteristics of their formation cycles, which means that for some battery cells, anomalies in the current flow may occur more frequently after electrolyte filling or at specific time instances during the formation of the battery cell - for example at the beginning or the end of the formation cycle or after 30% or 50% of the formation cycle. The time instances at which the determining the current flow is performed may account for these time characteristics of the battery cell formation, for example by more frequently repeating the determining the current flow at specific times, e.g. at the beginning (i.e. during the first 20% of the battery cell formation), at a time corresponding to 30%, 40%, or 50%, or at the end of the battery cell formation. Determining anomalies in the electrical current at the beginning (i.e. during the first 20% of the battery cell formation) may be preferred, because the chemical/physical rate of change within the battery cell is particularly high, meaning that anomalies may be detectable with a high accuracy. Further, identifying anomalies that may lead to faulty battery cells already at the beginning of the battery cell manufacturing has the benefit that the formation process for this battery cell may be canceled early, thus reducing the waste of resources that would be needed for fully running the battery cell manufacturing process. Depending on the manufacturing equipment that is used for manufacturing the battery cells, manufacturing of an individual battery cell may be canceled or an entire batch of battery cells may be canceled. In the latter case, the canceling of the manufacturing may be performed once anomalies have been identified in a substantial portion of the battery cells of the batch (e.g. more than 20%, or 30% of the battery cells).

In some preferred embodiments, the determining the current flow within the battery cell comprises moving the contactless current sensor and the battery cell relatively to each other within the manufacturing equipment and determining the current flow by scanning the current flow during the relative motion of the contactless current sensor and the battery cell. By performing a relative motion between the current sensor and the battery cell, the spatial sensitivity of the current sensor may be improved. For example, a single current sensor may be moved relative to the battery cell in order to determine the current flow in a spatially resolved manner. In other examples, the current sensor may comprise an array of a plurality of current sensing elements, as will be described in more detail below. For example, if the spatial extend of the array is smaller than the spatial extend of the current sensor, the array may be moved relatively in order to a achieve the aforementioned spatial resolution. Additionally, the relative motion allows to measure the current flow in battery cells which have a higher spatial extend than the current sensor.

In some preferred embodiments, the method may comprise identifying deviations in the determined current flow. This may be performed, for example, by comparing the determined current flow with an expected current flow and identifying that the determined current flow is less than expected.

Additionally or alternatively, the identifying deviations in the measured current flow may comprise generating a current measurement map for one or more areas of the battery cell based on the determined current flow. The abovementioned issue of storing large amounts of data may be particularly relevant for some embodiments that generate current measurement maps with high spatial resolution, which means that the abovementioned aspects of selectively storing data may apply to these embodiments in which current measurement maps are generated. The spatial resolution that is needed for generating a current measurement map may be achieved by the current sensor comprising an array of a plurality of current sensing elements or performing a relative motion of the current sensor relative to the battery cell as mentioned with respect to some of the abovementioned preferred embodiments. A current measurement map may be evaluated based on a variety of algorithms.

One example of evaluating a current measurement map is to compare each individual point of a current measurement map with a threshold value. This way, anomalies may be identified by identifying "hot spots". Different current sensors may have the same or individual threshold values. Also, the thresholds may be different for different locations of a battery cell - e.g. the threshold may be different in a center region of the battery cell and an edge region of the battery cell. Alternatively or additionally, each individual point of a first current measurement map may be compared with a corresponding point of a second (e.g. a subsequent) current measurement map.

In other examples, regions of a battery cell (e.g. regions of interest) may be defined and the current measurement map may be evaluated based on the defined regions. For example, for each region the measured current flow may be compared to an expected current flow.

Further, in embodiments in which multiple battery cells are formed in a manufacturing equipment, a current sensor may be provided for each battery cell. In these embodiments, the current measurement maps may be evaluated by comparing the current measurement maps of the multiple battery cells and identifying deviations.

In some embodiments, two or more current sensors may be used to evaluate a single battery cell. In such cases, combinations (e.g. averages) of the measurements of the two or more current sensors may be evaluated - e.g. by comparing with a predetermined threshold. Alternatively, the measurements of each of the two or more current sensors may be compared with one another. In one particular example, an average of the two or more current sensors may be calculated and the deviation from this average may be determined for each current sensor.

Further, some algorithms may use statistic methods to determine anomalies in the current measurements. For example, cross-correlation maybe performed based on a current measurement map obtained by one or more current sensors and a predetermined (e.g. reference) map.

Some other algorithms may be based on an artificial intelligence model. The artificial intelligence may be trained with training data and may be configured to determine deviations of the current flow. The training data may comprise a set of current maps that include current maps for normal operating cells as well as current maps for faulty cells. Further, the training data may include information about lifetime of a cell. Thereby, the artificial intelligence may be configured to predict an expected lifespan of a battery cell. The process of training the artificial intelligence model may also be called machine learning. The artificial intelligence may operate, for example based on recognition of a pattern in a current measurement map. The training of the artificial intelligence may be performed with a reference battery cell. Further, the artificial intelligence may be configured to redefine its operation during application. In some embodiments, the artificial intelligence may not only redefine the identification of anomalies in the current measurements, but also redefine a temporal behavior of the measurements (e.g. a frequency of the measurements may be redefined) or additionally or alternatively, the artificial intelligence may redefine parameters of the spatial behavior of the measurements (e.g. regions of interests may be redefined).

Regardless of the particular algorithm or model that is used to determine anomalies in the current measurement, the information obtained by the respective algorithm or model may also be used to grade the battery cells. Often, the decision whether or not a battery cell is faulty is a clear-cut case. However, properly operating battery cells may have different qualities. These aforementioned results obtained by the disclosed algorithms and models may be used to determine the quality of a battery cell, thereby enabling grading cells in different quality classes. In order to determine different quality classes, parameters for grading the battery cells may be predetermined or provided by an artificial intelligence model, wherein the artificial intelligence model may readjust the parameters during application.

In some preferred embodiments, the method comprises applying pressure to the battery cell during formation of the battery cell. For example, a support structure may be provided that is configured to apply pressure onto the battery cell during formation. Applying pressure to the battery cell during formation may increase the resistance of the battery cell during the charging and discharging process of the formation cycle. The increased resistance due to the applied pressure may improve the formation of the battery cell, for example by increasing the capacity of the battery cell.

The abovementioned preferred embodiments are not exclusive. Instead, combinations of two or more aspects of the abovementioned preferred embodiments lie within the scope of the invention. As such, all the aforementioned aspects or embodiments are freely combinable.

The abovementioned need is also fulfilled by a contactless current sensor that is configured to be used according to the abovementioned method. The current sensor may have any of the configurations that are disclosed in combination with the abovementioned method, including, for example, an array comprising a plurality of current sensing elements, wherein the current sensing elements may be evenly or unevenly distributed.

The abovementioned need is also fulfilled by a manufacturing equipment configured to perform at least one step of manufacturing one or more battery cells. The at least one step of manufacturing the one or more battery cells comprises filling the battery cell with an electrolyte, charging the battery cell, and discharging the battery cell. The manufacturing equipment comprises one or more contactless current sensors, wherein each current sensor comprises at least one current sensing element for determining a current flow within at least one of the one or more battery cells during or after said at least one step of manufacturing.

The manufacturing equipment may further comprise one or more support structures. The one or more contactless current sensors may be arranged on the one or more support structures. Further, the one or more support structures may be moveable relatively to one or more battery cells, thereby allowing a relative motion between the one or more current sensors and the one or more battery cells as described above.

Additionally or alternatively, the one or more support structures may be configured to apply pressure onto the one or more battery cells during formation in order to enhance the formation process. For example, the manufacturing equipment may comprise a stack of battery cells and support structures, wherein the support structures are configured to apply pressure onto the battery cells throughout the stack. In some examples, multiple support structures may be rigidly connected, such that when a force is applied to one of the support structures, the force is transferred by the rigid connection to all support structures, thereby pressing the support structures onto the battery cells.

Whereas in some embodiments, each of the one or more support structures may be configured support one of the current sensors and to apply a force onto the battery cell at the same time, in some other embodiments, the manufacturing equipment may comprise a first set of support structures that are configured to support the current sensors and a second set of support structures that are configured to apply a force onto the battery cells.

In some embodiment examples, the manufacturing equipment comprises a plurality of current sensors and a plurality of battery cells. In some embodiments, the current sensors and the battery cells may be stacked in an alternating manner. In some embodiments, each current sensor may be configured to determine the current flow in a single directly neighboring battery cell, but in some other embodiments, each current sensor may be configured to determine the current flow in both directly neighboring battery cells. In these cases, the current sensor may be configured to determine the current flow in both neighboring battery cells either simultaneously or sequentially.

In the embodiment examples in which the battery cells are formed under pressure, the manufacturing equipment may preferably be a formation equipment for forming battery cells or may comprise such a formation equipment.

### BRIEF DESCRIPTION OF THE DRAWINGS

The following description and the annexed figures set forth in detail certain illustrative aspects of the (contactless) current sensor according to the current invention. These aspects are indicative, however, of but a few of the various ways in which the principles of various embodiments can be employed and the described embodiments are intended to include all such aspects and their equivalent.

In the figures, like reference characters generally refer to the same parts throughout the different figures. The figures are not necessarily to scale. Instead, a general focus is put on an explanation of the universal principles of the invention.

In the following description, various embodiments of the invention are described with reference to the following figures:
- FIG. 1: shows a pouch cell as example for a battery cell, wherein (a) is a side view of a pouch cell and (b) is sectional view of a pouch cell;
- FIG. 2: shows a first embodiment example of a contactless current sensor, wherein (a) is a top view of a contactless current sensor and (b) is a side view of a relative arrangement of the contactless current sensor and a battery cell;
- FIG. 3: shows a second embodiment example of a contactless current sensor, wherein (a) is a top view of a contactless current sensor and (b) is a side view of a relative arrangement of the contactless current sensor and a battery cell;
- FIG. 4: shows a third embodiment example of a contactless current sensor, wherein (a) is a top view of a contactless current sensor and (b) is a side view of a relative arrangement of the contactless current sensor and a battery cell;
- FIG. 5: shows a fourth embodiment example of a contactless current sensor in which the contactless current sensor is moved relatively to the battery cell, wherein figure 5 shows a relative arrangement of the contactless current sensor and a battery cell in (a) a top view and (b) a side view;
- FIG. 6: shows an embodiment example of a system configured for determining the current flow in a battery cell during formation under pressure, wherein figure 6 shows a corresponding contactless current sensor, a support structure for applying pressure and a battery cell (a) in a state without applied pressure and (b) in a state with applied pressure;
- FIG. 7: shows an embodiment example of a stack of the system illustrated in figure 6.

### DETAILED DESCRIPTION

The following detailed description refers to the accompanying figures that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

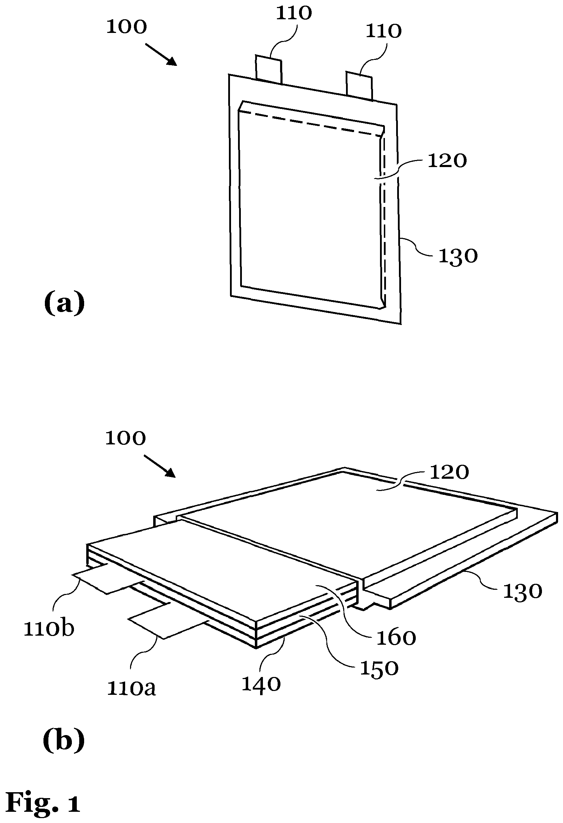

Figure 1 shows a pouch cell as example for a battery cell, wherein (a) is a side view of a pouch cell and (b) is sectional view of a pouch cell. For reasons of simplification, the invention will be illustrated for the example of a contactless current sensor determining a current flow in a pouch battery cell. Because of the shape of the pouch cell, in which the battery cell has a planar configuration that can be simplified as a stack of layer-shaped electrodes and separation layer, which each extend in two-dimensional space, the invention can be easily explained. However, the skilled person will appreciate that the invention is not limited to pouch-type battery cells, even though these represent an important application example.

In figure 1 (a) a pouch-type battery cell is generally shown at 100. The battery cell 100 comprises a cell casing 130 and a body portion 120. The cell casing 130 may be formed by a pouch foil. The body portion 120 is formed by a stack of layers. An example of such a layered structure is illustrated in figure 1 (b). In this example, an anode layer 140, a separation layer 150 and a cathode layer 160 are stacked and encased by the cell casing 130. The anode layer 140 and the cathode layer 160 may be formed by an anode foil and a cathode foil, respectively. Each of the anode layer 140 and the cathode layer 160 ends in a cell tab 110a, 110b, respectively.

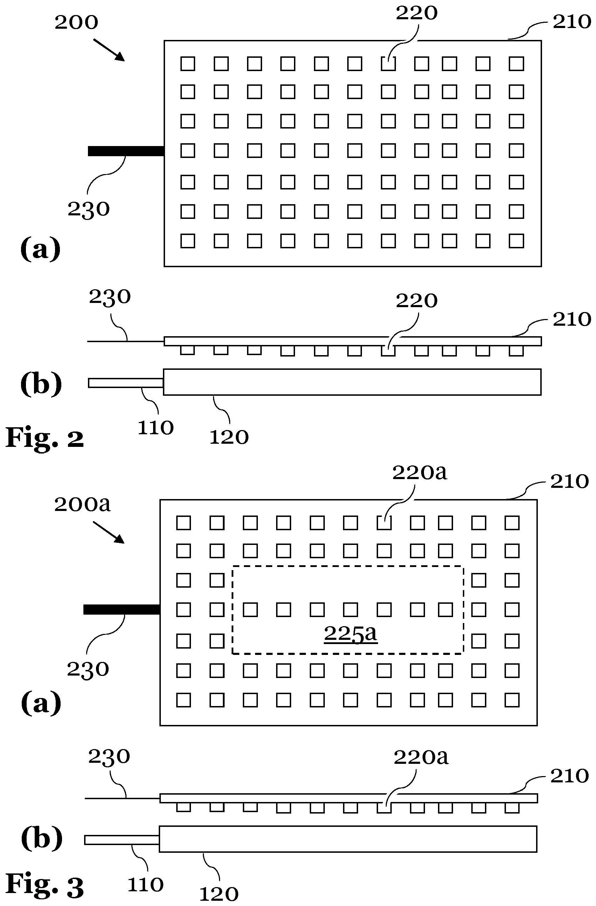

Figure 2 shows a first embodiment example of a contactless current sensor, wherein (a) is a top view of a contactless current sensor and (b) is a side view of a relative arrangement of the contactless current sensor and a battery cell. As mentioned above, the batter cell may be a pouch battery cell as illustrated in Figure 1.

In the depicted embodiment example, a current sensor is generally shown at 200. The current sensor comprises a substrate 210 that provides support for a plurality of current sensing elements 220. In the depicted embodiment example, the plurality of current sensing elements 220 are arranged in an array. In this example, the number of current sensing elements and their relative distance are selected in order to completely cover a single battery cell with essentially homogenous spatial resolution of the current flow measurement. For data readout, the current sensor further comprises a terminal 230 that may be used to connect the current sensor with a monitoring system. As the skilled person will appreciate, the current sensor may provide raw data that can be evaluated by the monitoring system or the current sensor may comprise a dedicated evaluation circuit that is configured for analyzing the data corresponding to the current flow measurement. In some embodiments of the invention, the substrate 210 may be a printed-circuit board (PCB) and the current sensing elements may be arranged as integrated circuits (e.g. packaged integrated circuits).

In the side view of figure 2 (b), the arrangement of the current sensor 200 relative to a battery cell is illustrated. In the here shown embodiment example, the current sensor determines the current flow by ease of a magnetic (e.g. via a magnetoresistance element, a magnetoimpedance sensing element, or a fluxgate magnetometer) or inductive measurement. No physical contact between the current sensor 200 and the battery cell is needed, as is illustrated in figure 2 (b). In general, it can also be said the current sensor 200 measures the current flow or current flow distribution within the cell 120 indirectly, namely via another physical property which is influenced by the current within the cell 120 such that no contact is necessary. Physical properties which can be measured are all physical properties which are influenced by the current flow or current flow distribution within the cell 120. For example, the magnetic field may be one physical property which is influenced by the current or current distribution within cell 120. Another physical property may be the ambient temperature which is influenced by the current or current distribution within cell 120. The named physical properties have in common that they can be measured without the need of conductive contact between the sensor 200 or the sensor elements 220 and the cell 120. Due to this it can also be said that the sensor 200 is a contactless current sensor 200.

Figure 3 shows a second embodiment example of a contactless current sensor, wherein (a) is a top view of a contactless current sensor and (b) is a side view of a relative arrangement of the contactless current sensor and a battery cell. The current sensor according to the second embodiment example comprises similar features to the first embodiment example of figure 2. Features that are similar or identical have the same reference sign, whereas features in which the second embodiment example differs from the first embodiment example have an "a" added to the reference sign.

The current sensor 200b illustrated in figure 3 comprises a plurality of current sensing elements 220a, which are again arranged in an array. Contrary to the plurality of current sensing elements 220 of current sensor 200 in figure 2, the plurality of current sensing elements 220a of current sensor 200a in figure 3 is not homogeneously distributed over the entire spatial extend of the substrate 210. Instead, the current sensor 200a comprises a center region 225a in which the current sensing elements are more sparsely distributed. In other words, the plurality of current sensing elements 220a of the current sensor 200a may comprise a first subset of current sensing elements arranged in a center region 225a of the current sensor 200a and a second subset of current sensing elements arranged in an edge region of the current sensor 200a, wherein the current sensing elements are more densely arranged in the edge region compared to the center region 225a.

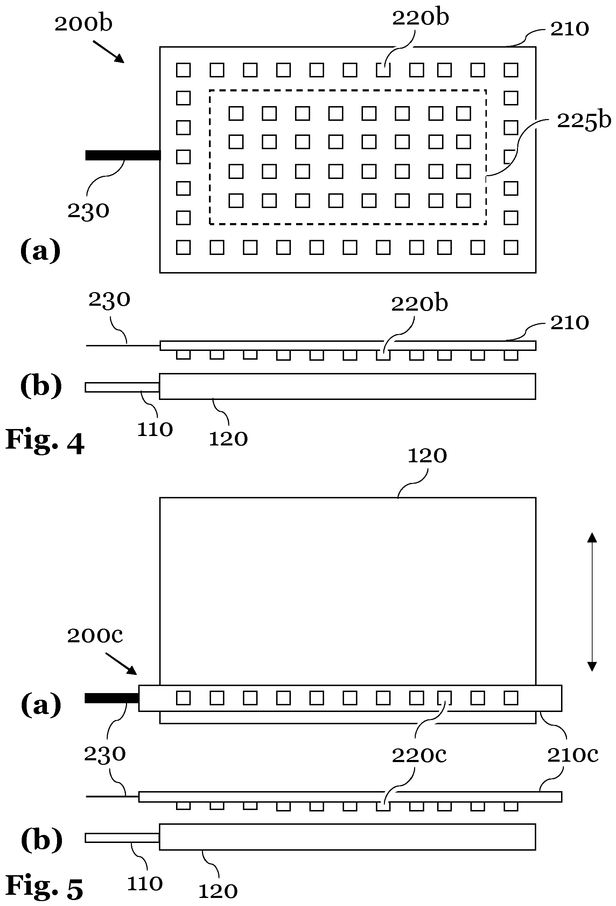

Figure 4 shows a third embodiment example of a contactless current sensor, wherein (a) is a top view of a contactless current sensor and (b) is a side view of a relative arrangement of the contactless current sensor and a battery cell. The current sensor according to the third embodiment example comprises similar features to the first embodiment example of figure 2. Features that are similar or identical have the same reference sign, whereas features in which the second embodiment example differs from the first embodiment example have a "b" added to the reference sign.

The current sensor 200b illustrated in figure 3 comprises a plurality of current sensing elements 220a, which are again arranged in an array. Similarly to the second embodiment example illustrated in figure 3, the current sensing elements 200b of current sensor 200b are not evenly distributed over the entire extend of the current sensor 200b. In the third embodiment example, the plurality of current sensing elements 220b is divided into two subsets, wherein each subset forms an array, each array having a homogeneous spacing, but the spacings of the array in the center region 225b being different or offset to the array in the edge region.

The skilled person will appreciate that the aforementioned embodiment examples are described for facilitating the understanding of the reader and are not intended to limit the scope of the disclosure. Multiple other ways to arrange the plurality of current sensing elements on a current sensor are possible and fall within the scope of the invention. Additionally, in some examples a single current sensing element may be sufficient to determine the current flow in a battery cell - for example if the battery cell is rather small or the current sensor is moved relatively to the battery cell. The latter will be explained in more detail below with respect to figure 5.

Further, the skilled person will appreciate that in case that a current sensor comprises multiple current sensing elements, the read-out for the multiple current sensing elements may be performed simultaneously or sequentially. Further, the read-out may be performed simultaneously for the current sensing elements of one subset at a time.

In the illustrated embodiment examples of the current sensors 200, 200a, 200b, and 200c, the current sensing elements are indicated by ease of squares. In some applications, all current sensing elements of a current sensor may be of the same type (e.g. Hall effect-based or magnetoresistance-based current sensing elements). However, in some embodiment examples, different types of current sensing elements may be used in a current sensor. For example, a current sensor may comprise different current sensing elements in a center region and an edge region, but in other embodiment examples, a current sensor may comprise different types of current sensing elements in one region. As a non-limiting example, a current sensor similar to the current sensor 200a of figure 3 may comprise two types of current sensing elements in the edge region and a single type of current sensing elements in the center region 225a, or two types of current sensing elements in the edge region and two types of current sensing elements in the center region 225a, or a single type of current sensing elements in the edge region and two types of current sensing elements in the center region 225a, or a single type of current sensing elements in the edge region and a single type of current sensing elements in the center region 225a. Further, the types of current sensing elements in the edge region and the center region may be the same or may be different. The combinations of current sensing elements may include combinations of types of current sensing elements that are configured for performing magnetoresistance-based measurements with types of current sensing elements that are configured for performing temperature-based measurements. Further, the different types of current sensing elements may also comprise current sensing elements that perform the same type of measurements, but have different sensitivity, which may improve resolution of current flow measurements in certain regions of a battery cell. Additionally or alternatively, current sensing elements of different types may have different measurement ranges, which may be of particular use in case that the current flow is expected to be inhomogenous in certain types of battery cells.

In some examples, each square 220, 220a, 225a, 220b (or subsets of these squares) of the current sensors 200, 200a, 200b may represent a combination of a magnetic-based current sensing element and a temperature-based current sensing element, which allows to measure current flow by magnetic-based measurements and temperature-based measurements at the same or subsequent times with the same sensor.

Figure 5 shows a fourth embodiment example of a contactless current sensor in which the contactless current sensor is moved relatively to the battery cell, wherein figure 5 shows a relative arrangement of the contactless current sensor and a battery cell in (a) a top view and (b) a side view.

In figure 5 (a), a current sensor is generally shown at 200c. The current sensor 200c comprises a substrate 210 that provides support for a plurality of current sensing elements 220c and a terminal 230. In the depicted embodiment example, the plurality of current sensing elements 220c are arranged in a line, but the skilled person will appreciate that other configurations (including a single current sensing element) are encompassed by the disclosure of the invention.

The current sensor 200c is moved relatively to the battery cell. Since the current flow during formation of the battery cell is of interest, the current sensor 200c is moved relatively to the body portion 120 of the battery cell, where the stacked layers of the anode layer, separation layer and cathode layer are located. The movement of the current sensor 200c is illustrated by the arrow in figure 5 (a). Depending on the configuration of the battery cell and the current sensor 200c - in particular the one or more current sensing elements 220c - the movement may be performed in a linear fashion as indicated in figure 5 (a) or in other ways. For example, in case that the one or more current sensing elements do not cover the spatial extend of the battery cell in a particular direction, a movement in this direction may be performed. In figure 5 (b), the plurality of current sensing elements 220c fully covers the battery cell in the second direction of the two-dimensional plane of the figure that is perpendicular to the arrow of figure 5 (b). Hence, no movement in this direction is necessary. If the current sensor 200c would have a smaller number of current sensing elements 220c (e.g. only the first square on the left hand side of figure 5 (a)), a motion in the second spatial direction perpendicular to the arrow would be necessary in order to obtain information about the current flow in the entire battery cell.

By ease of the aforementioned motion of the current sensor 200c relatively to the battery cell, the battery cell may be scanned in order to obtain information about the current flow in the entire battery cell. Preferably, the motion is performed stepwise, which means that the current flow is determined when the current sensor 200c is in a first location, then the current sensor 200c is displaced and moved to a second location, where another determination of the current flow is performed and so on until the battery cell has been sufficiently scanned.

The abovementioned comments on current sensing elements having different types or sensitivities with reference to figures 2 to 4 also apply to embodiment examples in which the current sensor is moveable relative to the battery cell as illustrated in figure 5.

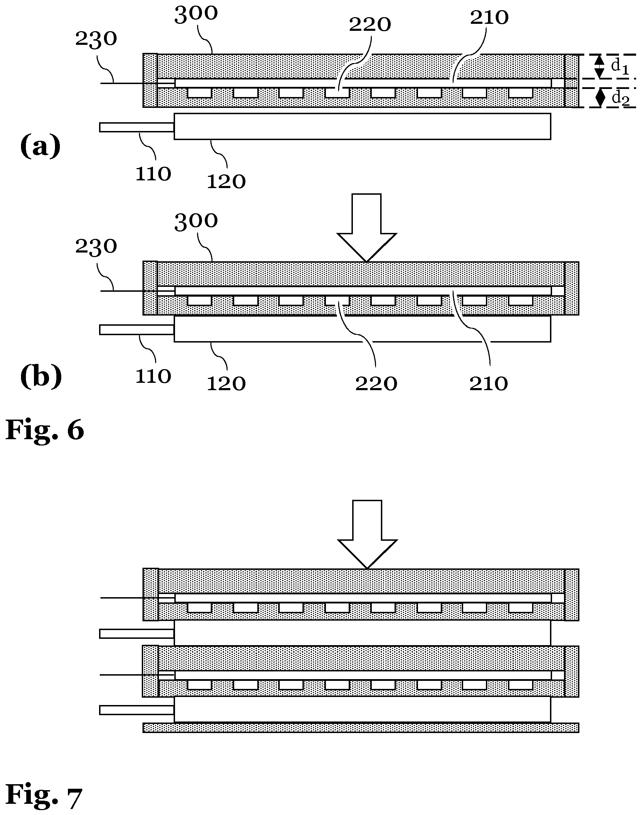

Figure 6 shows an embodiment example of system configured for determining the current flow in a battery cell during formation under pressure, wherein figure 6 shows a corresponding contactless current sensor, a support structure for applying pressure and a battery cell (a) in a state without applied pressure and (b) in a state with applied pressure.

In figure 6 (a), a current sensor and a battery cell similar to the current sensor 200 in figure 2 and the battery cell 100 in figure 1 are depicted. The current sensor is arranged in a support structure 300. For example, the current sensor is arranged in a recess, or in an opening in the support structure. The support structure 300 is configured to apply pressure to the battery cell in order to enable formation of the battery cell under pressure, which has proven to increase the efficiency of the formation process. The support structure has a top portion and a bottom portion, which are rigidly connected. The current sensor may be located in a recess or opening between the top and bottom portions. In figure 6 (b), the applied pressure is illustrated by the arrow. Noteworthy, the support structure transfers pressure from the top surface to the bottom surface to apply pressure on the battery cell but does not apply pressure to the current sensor, since this pressure may damage the support structure. Instead, the current sensor is arranged within or held by the support structure and the pressure is applied only to the battery cell.

Figure 7 shows an embodiment example of a stack of the system illustrated in figure 6. Since a formation equipment typically forms multiple battery cells at the same time, applying pressure at the same time to multiple battery cells is necessary. Figure 7 illustrates that battery cells, which are formed in a formation equipment in a stacked manner, are interleaved with support structures. Each support structure applies pressure to its neighboring battery cell - either by the entire stack being compressed and the force that is applied to a first support structure located at the top of the stack is transferred via the battery cell to the neighboring support structure that then applies pressure to the next battery cell and so on, or the different support structures may be connected, such that when a force is applied to one of the support structures, the force is transferred to all connected supported structures.

In the depicted embodiment example, each support structure comprises a reception for a current sensor. While it may be preferred to have a dedicated current sensor for each battery cell, in some applications a smaller number of current sensors may be used and each current sensor may determine the current flow in its two directly neighboring battery cells of the stack.

In cases in which each battery cell is evaluated with a dedicated current sensor, the support structure may be configured to reduce cross-talk between neighboring sensors. This may be achieved by increasing the distance d1 in which the support structure holds the current sensor relatively to the neighboring battery that is not of interest (e.g. distance d1 is represented by the height of the upper section of the support structure 300 in figure 6 (a)) compared to the distance d2 in which the support structure holds the current sensor relatively to the neighboring battery for which the current sensor shall determine the current flow (e.g. distance d2 is represented by the height of the lower section of the support structure 300 in figure 6 (a)).

In some embodiment examples, the support structures 300 may comprise a means for holding the current sensor 200, wherein the means for holding is also configured to move the current sensor 200 relatively to the battery cell 100 within the support structure 300.

What has been described above includes examples of one or more embodiments. It is, of course, not possible to describe every conceivable combination of components or methodologies for purposes of describing the aforementioned embodiments, but one of ordinary skill in the art may recognize that many further combinations and permutations of various embodiments are possible. Accordingly, the described embodiments are intended to embrace all such alterations, modifications and variations that fall within the spirit and scope of the appended claims.

## Claims

1. A method for determining current flow in a battery cell (100) during manufacturing of the battery cell (100), the method comprising:
arranging a contactless current sensor (200, 200a, 200b, 200c) relatively to the battery cell (100), wherein the contactless current sensor (200, 200a, 200b, 200c) comprises at least one current sensing element (220, 220a, 225a, 220b, 225b, 220c);
performing at least one of:
filling the battery cell (100) with an electrolyte,
charging the battery cell (100), and
discharging the battery cell (100); and
determining, by the contactless current sensor (200, 200a, 200b, 200c), a current flow within the battery cell (100) during or after said at least one of the filling the battery cell (100) with the electrolyte, the charging the battery cell (100), and the discharging the battery cell (100).

2. The method according to claim 1, wherein the at least one current sensing element (220, 220a, 225a, 220b, 225b, 220c) is any of:
a Hall element;
a magnetoresistance element, including elements that are sensitive to the colossal magnetoresistance, CMR, effect, the giant magnetoresistance, GMR, effect, and the tunnel magnetoresistance, TMR,
a magnetoimpedance sensing element,
a fluxgate magnetometer,
a microelectromechanical systems, MEMS, magnetometer, or
an inductive sensing element.

3. The method according to any of the aforementioned claims, wherein the determining the current flow within the battery cell (100) is based on measurement of at least one magnetic field gradient.

4. The method according to any of the aforementioned claims, wherein the at least one contactless current sensor (200, 200a, 200b, 200c) comprises an array comprising a plurality of current sensing elements (220, 220a, 225a, 220b, 225b, 220c), wherein the current sensing elements (220, 220a, 225a, 220b, 225b, 220c) of the plurality of current sensing elements (220, 220a, 225a, 220b, 225b, 220c) are evenly distributed in a plane or wherein the current sensing elements (220, 220a, 225a, 220b, 225b, 220c) of the plurality of current sensor elements (220, 220a, 225a, 220b, 225b, 220c), when arranged relatively to the battery cell (100), are more densely distributed in edge regions of the battery cell (100) compared to a center region of the battery cell (100).

5. The method according to claim 4, wherein the determining the current flow within the battery cell (100) is performed simultaneously for every current sensing element (220, 220a, 225a, 220b, 225b, 220c) of the array of current sensing elements (220, 220a, 225a, 220b, 225b, 220c) or performed sequentially for subgroups of one or more sensing elements (220, 220a, 225a, 220b, 225b, 220c) of the array of current sensing elements (220, 220a, 225a, 220b, 225b, 220C).

6. The method according to any of the aforementioned claims, wherein determining a current flow within the battery cell (100) comprises:
moving the contactless current sensor (200, 200a, 200b, 200c) and the battery cell (100) relatively to each other; and
determining the current flow by scanning the current flow during the relative motion of the contactless current sensor (200, 200a, 200b, 200c) and the battery cell (100).

7. The method according to any of the aforementioned claims, further comprising:
identifying deviations in the determined current flow.

8. The method according to claim 7, wherein identifying deviations in the measured current flow comprises at least one of:
generating a current measurement map for one or more areas of the battery cell (100) based on the determined current flow; and
comparing the determined current flow to one or more predetermined values.

9. The method according to any of claims 7 or 8, wherein identifying deviations in the measured current flow involves the application of an artificial intelligence.

10. The method according to any of the aforementioned claims, wherein the determining the current flow is performed during at least one of the charging or the discharging the battery cell (100), and wherein the method further comprises:
applying pressure to the battery cell (100) during the at least one of charging or discharging the battery cell (100).

11. A contactless current sensor (200, 200a, 200b, 200c) configured to be used according to a method according to any of claims 1 to 10.

12. A manufacturing equipment configured to perform at least one step of manufacturing one or more battery cells (100), the at least one step of manufacturing the one or more battery cells (100) comprising:
filling the battery cell (100) with an electrolyte,
charging the battery cell (100), and
discharging the battery cell (100); and
the manufacturing equipment comprising one or more contactless current sensors (200, 200a, 200b, 200c) each comprising at least one current sensing element (220, 220a, 225a, 220b, 225b, 220c) for determining a current flow within at least one of the one or more battery cells (100) during or after said at least one step of manufacturing.

13. The manufacturing equipment according to claim 12, wherein the one or more contactless current sensors (200, 200a, 200b, 200c) are arranged on one or more support structures (300), wherein the one or more support structures (300) are configured to apply pressure onto the one or more battery cells (100) during manufacturing.

14. The manufacturing equipment according to any of claims 12 or 13, wherein a first current sensing elements of the at least one current sensing element (220, 220a, 225a, 220b, 225b, 220c) is placed between two neighboring ones of the battery cells (100) and is configured for determining current flows within two neighboring battery cells (100), wherein the first current sensing element preferably is configured to determine the current flows within the two neighboring battery cells (100) simultaneously or sequentially.

15. A battery cell (100) produced by a method that involves the determination of current flow during manufacturing of the battery cell (100) according to any of claims 1 to 10.
